# EUROPEAN PATENT APPLICATION

(11) **EP 4 568 120 A1**
(43) Date of publication of application: **11.06.2025**
(21) Application number: 24217283.1
(22) Date of filing: 03.12.2024
(51) Int. Cl.: H04B 1/38, H05K 1/00, H05K 5/00

(54) **INTRISICALLY SAFE DESIGNED DEVICES AND METHODS THEREFOR**

(30) Priority: 04.12.2023 US 202318527475
(71) Applicant: BlackBerry Limited, Waterloo, Ontario N2K 0A7 (CA)
(72) Inventor: JANTZI, Jason Wayne, Waterloo, N2K 0A7 (CA); DILL, Scott Leonard, Waterloo, N2K 0A7 (CA); OGLE, Alexander John, Waterloo, N2K 0A7 (CA); FULESHWAR PRASAD, Mahendra, Waterloo, N2K 0A7 (CA); SANTIAGO, Joseph Orais, Waterloo, N2K 0A7 (CA); GAO, Yu, Waterloo, N2K 0A7 (CA)
(74) Representative: MERH-IP Matias Erny Reichl Hoffmann Patentanwälte PartG mbB

(57) **Abstract**

Encapsulating components and millimeter-wave waveguides coupled to a circuit board to satisfy intrinsically safe requirements and methods therefor. The top side of the circuit board is divided into a plurality of zones using a plurality of fences formed by the housing of the apparatus. The plurality of zones, and the components and millimeter-wave waveguide therein, are filled with potting material.

## Description

### FIELD

The present application relates to an apparatus for protecting electrical circuits, and more specifically, it relates to an apparatus for encapsulating electrical circuits to prevent spark and thermal ignition so as to comply with intrinsically safe requirements and methods therefor.

### BACKGROUND

Components found on electrical circuit boards fail from time to time. Some failures can lead to catastrophic effects if the circuit boards are in close proximity to explosive or expensive cargo during transportation. The Association of American Railroads (AAR) has mandated that telematic device installations on Class 1 railroads must comply with the safety recommendations of the American National Standard Institute (ANSI). ANSI has recommended that telematic device installations must satisfy the intrinsically safe requirements outlined in the IEC 60079-11 and the IEC 60079-0 International Standards. Going forward, railroad companies require intrinsically safe devices to be installed on their trains and railcars.

Accordingly, it would be advantageous to have an electronics device that meets intrinsically safe requirements.

### BRIEF DESCRIPTION OF THE DRAWINGS

Reference will now be made, by way of example, to the accompanying drawings which show example embodiments of the present application. In the drawings:
FIG. 1 is a perspective view of a device filled with potting material in accordance with an example of the present application;
FIG. 2 is a close-up view of a plurality of zones of the device of FIG. 1.
FIG. 3 is a side view of the device with potting material applied in accordance with an example of the present application;
FIG. 4 is a perspective view of a battery holder with batteries therein in accordance with an example of the present application; and
FIG. 5 is a side view of the battery holder with the batteries therein of FIG. 4.
FIG. 6 shows a flowchart of an embodiment of a method of applying potting material to a device with a circuit board including a millimeter-wave waveguide.

Like reference numerals are used in the drawings to denote like elements and features.

### DETAILED DESCRIPTION OF EXAMPLE EMBODIMENTS

In one aspect, the present application describes a device for transmitting and receiving signals that satisfies intrinsically safe requirements. The device includes a circuit board. The circuit board includes a plurality of components. The circuit board includes a millimeter-wave waveguide. The device includes a housing. The housing is coupled to the circuit board. The housing coupled to the circuit board defines a plurality of zones. The plurality of zones is applied with potting material. The potting material encapsulates the plurality of components. The potting material encapsulates the millimeter-wave waveguide.

In some implementations, the circuit board has a top side. The circuit board has a bottom side. The housing is connected to the bottom side defining a plurality of cavities filled with the potting material.

In some implementations, the circuit board defines a plurality of holes. The plurality of holes is for the potting material to flow from the top side of the circuit board into the plurality of cavities.

In some implementations, the housing includes a plurality of fences. The plurality of fences is located on the top side of the circuit board defining the plurality of zones. The plurality of zones is filled with potting material.

In some implementations, a first zone of the plurality of zones encloses a first plurality of components of the plurality of components. The potting material in the first zone encapsulates the first plurality of components.

In some implementations, the plurality of fences defining the first zone is at least one mm higher than the first plurality of components. The thickness of the potting material from the first plurality of components to the first free surface of the potting material is at least one mm.

In some implementations, a second zone of the plurality of zones encloses the millimeter-wave waveguide. The potting material in the second zone encapsulates the millimeter-wave waveguide.

In some implementations, the plurality of fences of the second zone is at least one mm higher than the millimeter-wave waveguide. The thickness of the potting material from the millimeter-wave waveguide to a second free surface of the potting material is at least one mm.

In some implementations, a third zone of the plurality of zones encloses a second plurality of components of the plurality of components. The potting material in the third zone encapsulates the second plurality of components.

In some implementations, the plurality of fences defining the third zone is at least one mm higher than the second plurality of components. The thickness of the potting material from the second plurality of components to a third free surface of the potting material is at least one mm.

In some implementations, the device includes a battery cup and a battery therein. The area between the battery cup and the battery is filled with potting material.

In another aspect of the invention, the present invention describes a method for manufacturing an intrinsically safe device that includes a circuit board. The circuit board has a plurality of components. The circuit board has a millimeter-wave waveguide. The circuit board is coupled to a housing. The method includes applying a potting material atop the circuit board coupled to a housing. The method includes encapsulating the plurality of components using the potting material. The method includes encapsulating the millimeter-wave waveguide using potting material.

In some implementations, the circuit board has a top side. The circuit board has a bottom side. The housing is connected to the bottom side defining a plurality of cavities. The method includes filling the plurality of cavities with potting material.

In some implementations, the circuit board defines a plurality of holes therethrough. The method includes filling the plurality of cavities includes causing the potting material to drain using gravity through the plurality of holes of the circuit board to fill the plurality of cavities.

In some implementations, the housing has a plurality of fences above the top side of the circuit board. The plurality of fences defines a plurality of zones on the circuit board and enclose the plurality of components. The method includes encapsulation which comprises of filling the plurality of zones on the circuit board with the potting material.

In some implementations, encapsulation includes filling the plurality of zones on the circuit board with the potting material using gravity and the potting material flows between the plurality of zones using a plurality of holes defined by the circuit board.

In some implementations, a first zone of the plurality of zones encloses a first plurality of components of the plurality of components. The method includes encapsulating the first plurality of components by filling the first zone with the potting material.

In some implementations, a second zone of the plurality of zones encloses the millimeter-wave waveguide. The method comprises encapsulating the millimeter-wave waveguide by filling the second zone with the potting material.

In some implementations, the plurality of components includes a battery cup and a battery therein. The method includes applying the potting material to an area between the battery cup and the battery.

In some implementations, the method includes degassing the circuit board, the housing, the battery, the battery cup, and the potting material to prevent air and gas bubbles.

In some implementations, the method includes determining, in response to curing the potting material, whether the potting material has obtained a selected shore hardness. The method includes further curing the potting material to obtain the selected shore hardness.

In some implementations, the method includes determining the performance of the millimeter-wave waveguide of the circuit board. The method includes recalibrating, based on the performance, the circuit board due to interferences caused by the potting material.

Other aspects and features of the present application will be understood by those of ordinary skill in the art from a review of the following description of examples in conjunction with the accompanying figures.

In the present application, the term "and/or" is intended to cover all possible combinations and sub-combinations of the listed elements, including any one of the listed elements alone, any sub-combination, or all of the elements, and without necessarily excluding additional elements.

In the present application, the phrase "at least one of ... or... " is intended to cover any one or more of the listed elements, including any one of the listed elements alone, any sub-combination, or all of the elements, without necessarily excluding any additional elements, and without necessarily requiring all of the elements.

The present disclosure relates to devices or apparatuses, such as telematic device installations, applied with potting material to satisfy intrinsically safe requirements. In particular, it is an improvement in the safety of electrical circuit boards. Intrinsically safe apparatuses typically refer to electrical equipment in which the circuits are intrinsically safe circuits whilst in a hazardous area. Generally, an intrinsically safe circuit is a circuit in which any spark ignition or any thermal effect produced under the conditions specified in IEC 60079-11, which include normal operations and specified fault conditions, is not capable of causing ignition of a given explosive atmosphere.

Designing a device having a millimeter-wave waveguide component for radar cargo, container and load sensing that satisfies the intrinsically safe requirements is challenging. A millimeter-wave waveguide may be large compared with other components installed in a device and thus, the millimeter-wave waveguide may project above other components also installed in the device. Therefore, when potting material is applied to the device, the potting material may not completely enclose the millimeter-wave waveguide.

Accordingly, to encapsulate the millimeter-wave waveguide, a plurality of zones within the device is created using a plurality of fences. The plurality of fences is formed using the enclosure of the device. The height of the plurality of fences surrounding the millimeter-wave waveguide is greater than the height of the millimeter-wave waveguide. Therefore, the potting material may completely enclose the millimeter-wave waveguide.

To prevent spark ignition and help with thermal ignition to satisfy the intrinsically safe requirements, encapsulation of resin potting is used. The potting material is placed at least one (1) mm thick across all of the components of the device so that the total inductance (L) and total capacitance (C) does not count towards the spark ignition intrinsically safe total requirement. By placing plotting material over the components, many intrinsically safe requirements are relaxed (for example, component to component spacing, etc.).

Further, encapsulating a millimeter-wave radio frequency (RF) transceiver with potting resin may cause signal integrity issues, degradation of performance and loss of transmitter (Tx) to receiver (Rx) isolation. The presence of the potting material can cause signal loss through absorption and scattering of the electromagnetic waves propagated by the millimeter-wave waveguide. Accordingly, to prevent a degradation of performance of the millimeter-wave waveguide with the transceiver, potting material with certain characteristics for RF propagation is selected.

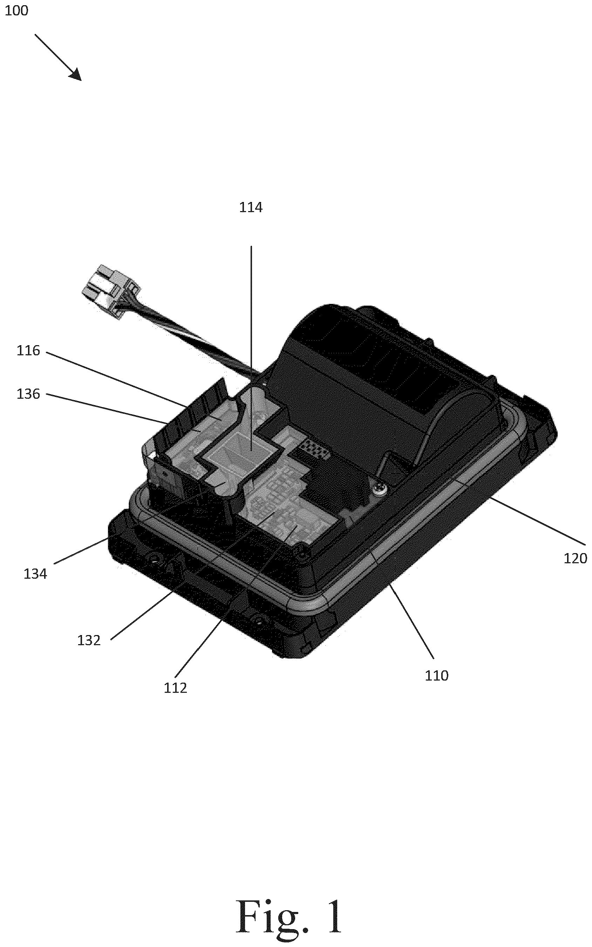

FIG. 1 illustrates a perspective view of an example of a device 100 filled with potting material. The device may be configured for transmitting and receiving signals. The device 100 may comply with intrinsically safe requirements. The intrinsically safe requirements may be outlined in the document IEC 60079-11 International Standard. The device 100 may include a circuit board 110. In other implementations, the device 100 may have one or more circuit boards. The device 100 may include a housing 120. The housing 120 may be of any size and shape depending on the size and shape of the circuit board 110.

The circuit board 110 may have a plurality of components. The circuit board 110 may include a millimeter-wave waveguide 114 (also known or referred to as a millimeter waveguide, mmWave waveguide or waveguide). The plurality of components may include passive components, such as switches, junction boxes, resistors, and simple semiconductors devices; and sources of stored energy, such as, capacitors, and inductors; and sources of generated energy, such as, thermocouples and photocells. The millimeter-wave waveguide 114 may also be waveguide of any type, such as, a rectangular waveguide, a circular waveguide, a double-ridged waveguide, a corrugated waveguide, a slotted waveguide, a tapered waveguide, a dielectric-loaded waveguide, and an integrated waveguide. In some cases, a Fresnel zone plate, a Fresnel lens, a Fresnel zone lens, a Fresnel zone plate lens, a hyperbolic lens, or a hyperbolic dome lens may be used instead of the millimeter-wave waveguide 114.

The plurality of components may include a first plurality of components 112 and a second plurality of components 116.

The housing 120 may be coupled to the circuit board 110 defining a plurality of zones. The plurality of zones are filled with potting material encapsulating the plurality of components therein and the millimeter-wave waveguide 114. The circuit board 110 may be connected, mounted, or attached to the housing 120. The circuit board 110 may be mounted on top of the housing 120. The circuit board 110 may be fastened to the housing 120.

The plurality of zones may include a first zone 132, a second zone 134 and a third zone 136. In some cases, the first plurality of components 112 is located in the first zone 132, the millimeter-wave waveguide 114 is located in the second zone 134, and the second plurality of components 116 is located in the third zone 136.

The potting material (also known as encapsulants or potting compounds) is used to protect or encapsulate the plurality of components. Various types of potting material may be used, such as silicone rubber or epoxy resin. The potting material may be opaque or transparent.

In some implementations, the potting material will have good fluidity before curing, small shrinkage after curing, and no small molecule by-products released during curing, good resistance to high temperature and low temperature, good resistance to sulfide and good dielectric properties when used in a closed environment at high temperature. For example, the operating temperature range of the potting material is between -60°C to 200°C. The potting material may be applied to the device 100 in a vacuum chamber.

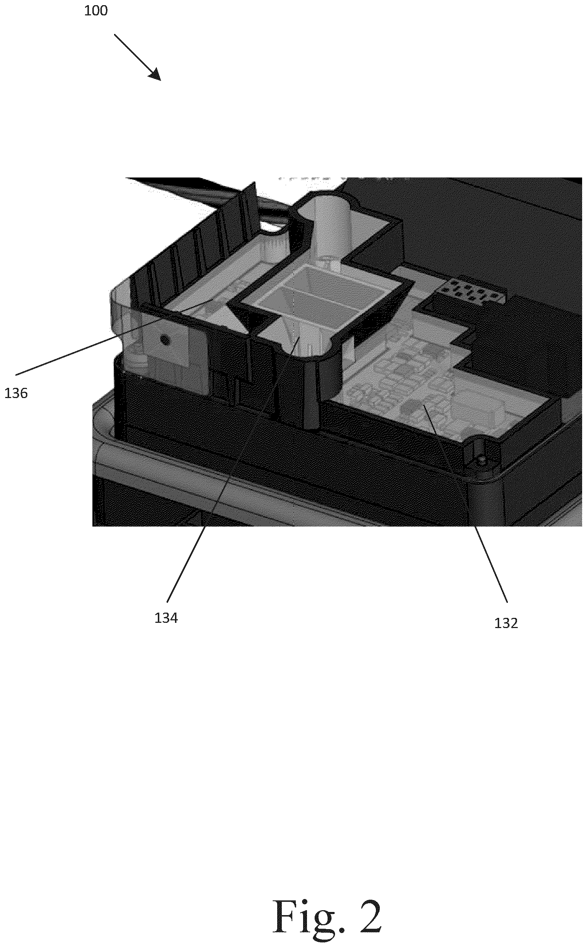

FIG. 2 illustrates a zoomed-in view of the plurality of zones of FIG. 1.

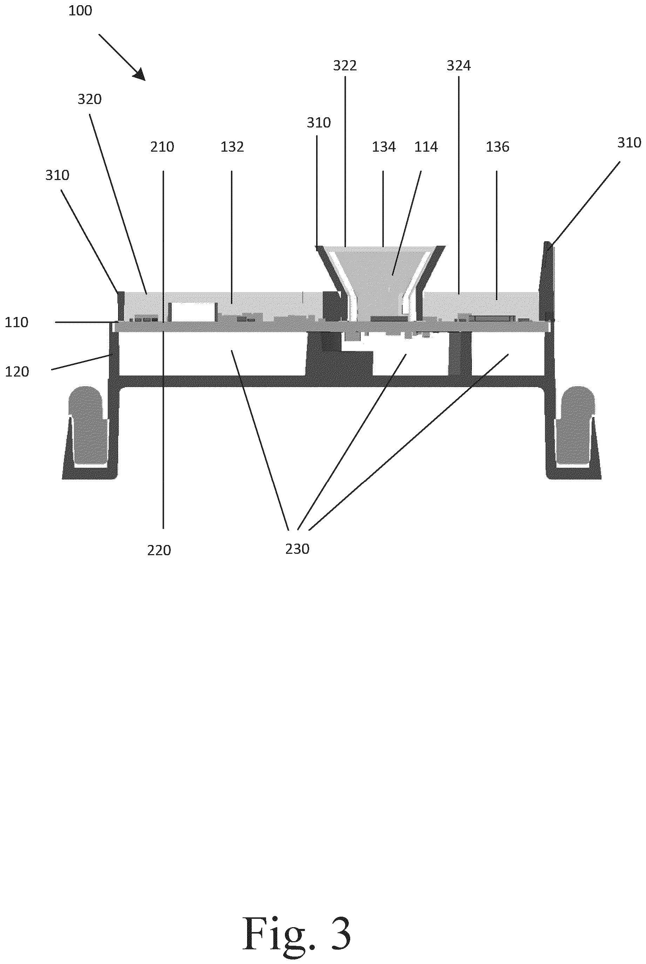

FIG. 3 illustrates a side view of the device 100 of FIG. 1. The circuit board 110 may have a top side 210 and a bottom side 220. The bottom side 220 of the circuit board 110 coupled with the housing 120 may define a plurality of cavities 230. The plurality of cavities 230 may also be known as sections, regions, or areas. The plurality of cavities 230 may be filled with plotting material (not shown). The housing 120 may have walls, pillars or blocks that provide the housing 120 structure to define the plurality of cavities 230 with the bottom side 220 of the circuit board 110. Put differently, the housing 120 supports or lifts the circuit board 110 using the walls. The housing 120 may be coupled to the circuit board 110 by fasteners, such as screws, clips, and adhesives.

In some implementations, the circuit board 110 may include a plurality of holes (not shown). For example, the plurality of holes may be defined by the circuit board 110. The plurality of holes may lead from the top side 210 of the circuit board to the bottom side 220 of the circuit board. The plurality of holes may be of any radius to permit the potting material to flow from the top side 210 to the bottom side 220 of the circuit board and into the plurality of cavities 230 before curing. The plurality of holes may be placed anywhere on the circuit board 110 and/or the housing 120 to permit the potting material to drain into the plurality of cavities 230. The draining effect may occur due to gravity. The potting material may completely fill the plurality of cavities 230 such that there are no air or gas bubbles therein.

In some implementations, the housing 120 may include a plurality of fences 310 on the top side 210 of the circuit board 110. The plurality of fences 310 may define a plurality of zones which are filled with potting material. Generally, the potting material should not overflow from the plurality of fences 310. In other implementations, the plurality of fences 310 may define a plurality of levels or a plurality of regions. Put differently, the plurality of fences 310 may divide up the circuit board 110 into a plurality of zones. The plurality of fences 310 may be based on the types of components installed on the circuit board 110. The plurality of fences 310 may be constructed based on the plurality of components on the circuit board 110. The plurality of fences 310 may be constructed around the components, such as the millimeter-wave waveguide 114. The plurality of fences 310 may not necessarily be vertical and have various shapes or designs. The plurality of fences 310 may be detached from the housing 120. For example, the plurality of fences 310 may be connected directly to the circuit board 110. The plurality of fences 310 may be aligned with the first plurality of components 112, the millimeter-wave waveguide 114, and/or the second plurality of components 116. The plurality of holes may permit the potting material to flow between the plurality of zones.

The first zone 132 of the plurality of zones may enclose a first plurality of components 112 of the plurality of components. The potting material in the first zone 132 encapsulates the first plurality of components 112. The first zone 132 may be a specified region on the circuit board 110 defined by the plurality of fences 310. Put differently, the plurality of fences 310 segregates the first plurality of components 112 from the other components on the circuit board 110 which results in the first zone 132. The potting material is poured into the first zone 132 in liquid or viscous form and then allowed to harden or cure. The potting material that is poured into the first zone 132 may not flow into the second zone 134. In other words, the potting material is confined to the first zone 132 when it is poured over the first zone 132, other than possibly flowing through holes or apertures in the circuit board 110 into one or more of the cavities 230.

The plurality of fences 310 defining the first zone 132 may be at least one millimeter higher than the first plurality of components 112. In some cases, the plurality of fences 310 defining the first zone 132 may be at least one millimeter higher than the highest component of the first plurality of components 112. The thickness of the potting material from the first plurality of components 112 to the first free surface of the potting material is at least one millimeter. A free surface may be defined as, once the potting material has hardened, the area of the potting material that is exposed to the atmosphere. The free surface may be flat on the horizontal plane. The free surface of the potting material may be level with the plurality of fences 310.

A first free surface 320 of the first zone 132 may be of different height than a second free surface 322 of the second zone 134 of the plurality of zones. Further, the first free surface 320 of the first zone 132 may be of different height than a third free surface 324 of the third zone 136 of the plurality of zones. In other words, the free surfaces of the plurality of zones may each have different heights.

In this example, the second zone 134 of the plurality of zones encloses the millimeter-wave waveguide 114. The potting material is poured into the second zone 134 and the millimeter-wave waveguide 114 found in the second zone 134 is filled with the potting material. In other words, the interior of the millimeter-wave waveguide is filled with the potting material. The potting material may not impact the performance of the millimeter-wave waveguide 114. The device 100 may be recalibrated to account for the impact of the potting material with the millimeter-wave waveguide 114. For example, the Rx gain of the device 100 may be recalibrated.

In some cases, the plurality of fences of the second zone 134 may be at least one mm higher than the millimeter-wave waveguide 114. In some cases, the plurality of fences of the second zone 134 may be at least one mm higher than the highest point of the millimeter-wave waveguide 114. The thickness of the potting material from the millimeter-wave waveguide 114 to the second free surface 322 of the potting material is at least one mm. The height of the second free surface 322 may be higher than the height of the first free surface 320, in part due to the fact the millimeter-wave waveguide 114 is significantly taller than the plurality of components found in the first zone 132 and the third zone 136.

The third zone 136 of the plurality of zones encloses a second plurality of components 116 of the plurality of components. The potting material in the third zone 136 encapsulates the second plurality of components 116.

The plurality of fences defining the third zone 136 is at least one mm higher than the second plurality of components 116. The thickness of the potting material from the second plurality of components 116 to the third free surface 324 is at least one mm.

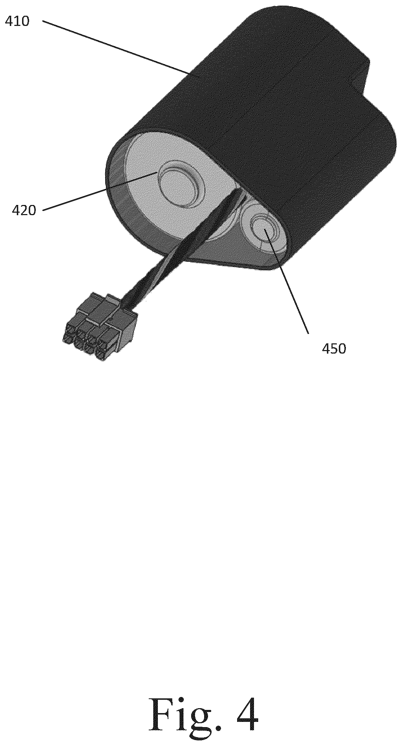

FIG. 4 illustrates a perspective view of a battery cup 410 and a battery 420 therein. The device 100 may comprise of a battery cup 410, a battery 420, and a capacitor 450. The battery cup 410 and the battery 420 therein may be removable from the device 100.

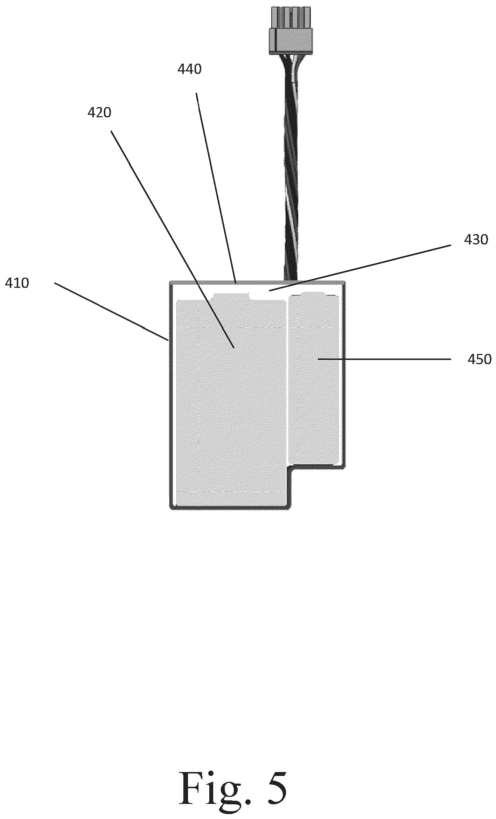

FIG. 5 illustrates a cross-section of the battery cup 410 and the one or more batteries 420 in FIG. 4. The area 430 between the battery cup 410 and the battery 420 is filled with the potting material. The distance between the battery 420 and a battery free surface 440 may be at least one mm. In some cases, the distance between the top of the battery 420 and the battery free surface 440 may be at least three mm.

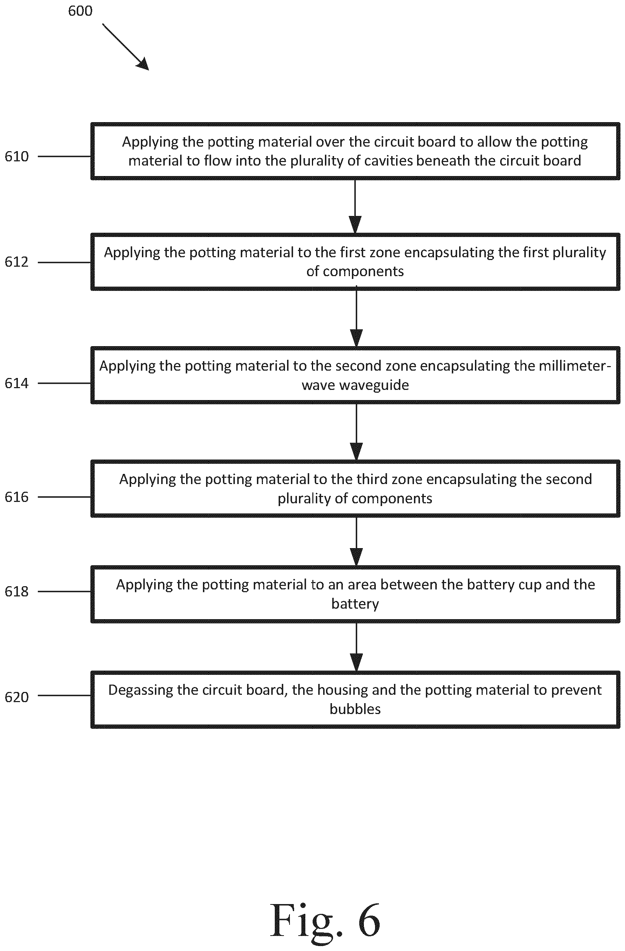

Reference now is also made to FIG. 6 in conjunction with FIGs. 1-3. FIG. 6 illustrates an example method 600 of applying a potting material onto a circuit board 110 having a plurality of components including a millimeter-wave waveguide 114.

In operation 610, the circuit board 110 may have a plurality of components including a millimeter-wave waveguide 114, the potting material may be applied to the circuit board 110 of the housing 120. The application of the potting material may include pouring the potting material over the plurality of components. The potting material may be prevented from flowing between zones by the plurality of fences 310. The potting material is generally contained within the plurality of fences 310.

In operation 610, the circuit board 110 has a top side 210 and a bottom side 220, and the housing 120 is connected to the bottom side 220 defining a plurality of cavities 230, the plurality of cavities 230 are filled with potting material. In operation 610, the circuit board 110 may have a plurality of holes (not shown). The potting material flows or passes through the plurality of holes to settle into the plurality of cavities 230. The plurality of cavities 230 may be completely filled with the potting material.

In operation 612, the potting material is applied to the first zone 132 encapsulating a first plurality of components 112. The plurality of fences 310 prevents the potting material from overflowing out of the device 100. In some cases, the plurality of fences prevents the potting material flowing from the first zone 132 into the second zone 134 or the third zone 136. Typically, the potting material does not overflow beyond the plurality of fences. In some cases, the potting material applied to the first zone 132 may flow into the second zone 134 through the plurality of holes defined by the circuit board 110.

The potting material may be poured onto the circuit board 110 and then the potting material is allowed to harden. After the potting material has hardened, no modifications can be made to the circuit board 110 as the circuit board 110 is encapsulated by the potting material. In some cases, the housing 120 may have an opening to allow the potting material to be poured onto the circuit board 110. In some cases, the potting material may be applied to the circuit board 110 in a vacuum chamber.

In operation 614, the potting material is applied to the second zone 134 encapsulating the millimeter-wave waveguide 114. The potting material may be applied until the second zone 134 is completely full of the potting material.

In operation 616, the method may include applying the potting material to the third zone 136 encapsulating a second plurality of components 116. The potting material may be applied until the third zone 136 is completely full of the potting material.

In operation 618, the potting material is applied to the area between the battery cup 410 and the battery 420 therein.

In operation 620, the circuit board 110, the housing 120, and the potting material therein is degassed to prevent air bubble from forming.

In some implementations, the method may further include determining, in response to curing the potting material, whether the potting material has obtained a selected shore hardness; and further curing the potting material, in response to failing to obtain the selected shore hardness, to obtain the selected shore hardness.

In some implementations, the method may further include determining a performance of the millimeter-wave waveguide 114 of the circuit board 110; and recalibrating, based on the performance, the circuit board 110 due to an interference by the potting material. In some cases, the method includes recalibrating the Rx gain based on the performance of the millimeter-wave waveguide 114 of the circuit board 110 or the interferences caused by the potting material.

The above discussed embodiments are considered to be illustrative and not restrictive. Certain adaptations and modifications of the described embodiments may be made. All such modification, permutations and combinations are intended to fall within the scope of the present disclosure.

## Claims

1. A device for transmitting and receiving signals that satisfies intrinsically safe requirements comprising:
a circuit board having a plurality of components including a millimeter-wave waveguide; and
a housing coupled to the circuit board defining a plurality of zones filled with a potting material encapsulating the plurality of components including the millimeter-wave waveguide.

2. The device of claim 1, wherein the circuit board has a top side and a bottom side, and the housing is connected to the bottom side defining a plurality of cavities filled with the potting material.

3. The device of claim 2, wherein the circuit board defines a plurality of holes for the potting material to flow from the top side of the circuit board into the plurality of cavities.

4. The device of claim 1 or 3, wherein the housing includes a plurality of fences on a top side of the circuit board defining the plurality of zones which are filled with the potting material.

5. The device of claim 4, wherein a first zone of the plurality of zones encloses a first plurality of components of the plurality of components, and the potting material in the first zone encapsulates the first plurality of components.

6. The device of claim 5, wherein the plurality of fences of defining the first zone is at least one mm higher than the first plurality of components, and a thickness of the potting material from the first plurality of components to a first free surface of the potting material is at least one mm.

7. The device of claim 6, wherein a second zone of the plurality of zones encloses the millimeter-wave waveguide and the potting material in the second zone encapsulates the millimeter-wave waveguide.

8. The device of claim 7, wherein the plurality of fences of the second zone is at least one mm higher than the millimeter-wave waveguide and a thickness of the potting material from the millimeter-wave waveguide to a second free surface of the potting material is at least one mm.

9. The device of claim 8, wherein a third zone of the plurality of zones encloses a second plurality of components of the plurality of components, and the potting material in the third zone encapsulates the second plurality of components; and optionally
wherein the plurality of fences defining the third zone is at least one mm higher than the second plurality of components, and a thickness of the potting material from the second plurality of components to a third free surface of the potting material is at least one mm.

10. The device of any one of claims 1 to 9, further comprising a battery cup and a battery therein, and wherein an area between the battery cup and battery is filled with the potting material.

11. A method for manufacturing an intrinsically safe device that includes a circuit board having a plurality of components including a millimeter-wave waveguide, the circuit board being coupled to a housing, the method comprising:
applying a potting material atop the circuit board; and
encapsulating the plurality of components including the millimeter-wave waveguide using the potting material.

12. The method of claim 11, wherein the circuit board has a top side and a bottom side, and the housing is connected to the bottom side defining a plurality of cavities, and wherein the method further includes filling the plurality of cavities with the potting material; and optionally
wherein the circuit board defines a plurality of holes therethrough and wherein filling the plurality of cavities includes causing the potting material to drain using gravity through the plurality of holes of the circuit board to fill the plurality of cavities.

13. The method of claim 11, wherein the housing has a plurality of fences above a top side of the circuit board, and the plurality of fences define a plurality of zones on the circuit board and enclose the plurality of components, wherein encapsulating includes filling the plurality of zones on the circuit board with the potting material; and optionally
wherein encapsulating includes filling the plurality of zones on the circuit board with the potting material using gravity and the potting material flows between the plurality of zones using a plurality of holes defined by the circuit board.

14. The method of claim 11, wherein a first zone of the plurality of zones encloses a first plurality of components of the plurality of components, and wherein encapsulating includes encapsulating the first plurality of components by filling the first zone with the potting material; and optionally
wherein a second zone of the plurality of zones encloses the millimeter-wave waveguide, and wherein encapsulating includes encapsulating the millimeter-wave waveguide by filling the second zone with the potting material.

15. The method of any one of claims 11 to 14, wherein the plurality of components includes a battery cup and a battery therein, and wherein the method further includes applying the potting material to an area between the battery cup and the battery; and optionally
wherein the method further comprises degassing the circuit board, the housing, the battery, the battery cup, and the potting material to prevent air or gas bubbles.
